# EUROPEAN PATENT APPLICATION

(11) **EP 2 051 108 A2**
(43) Date of publication of application: **22.04.2009**
(21) Application number: 08005718.5
(22) Date of filing: 27.03.2008
(51) Int. Cl.: G01T 1/24

(54) **Method of detecting x-rays and x-ray detecting apparatus**

(30) Priority: 17.09.2007 KR 20070093999
(71) Applicant: Samsung Electronics Co., Ltd., Suwon-si, Gyeonggi-do 442-742 (KR)
(72) Inventor: Jung, Kwan-Wook, Yeongtong-gu Suwon-si Gyeonggi-do (KR); Choo, Dae-Ho, Suji-gu Yongin-si Gyeonggi-do (KR)
(74) Representative: Weitzel, Wolfgang

(57) **Abstract**

Apparatus and method of accurately detecting X-rays employs a photodiode substrate wherein a first reverse bias is applied to the photodiode to generate a photodetect voltage according to the X-rays incident on the photodiode. After an image signal is output in response to the X-rays applied to the photodiode in the present frame, a forward bias is applied to the photodiode so that X-rays may be detected more accurately in the next frame.

## Description

### CROSS-REFERENCE TO RELATED APPLICATIONS

This application claims priority under 35 U.S.C. § 119 to Korean Patent Application No. 2007-93999, filed on September 17, 2007 in the Korean Intellectual Property Office (KIPO), the contents of which are incorporated herein by reference in their entirety.

### BACKGROUND OF THE INVENTION

### Field of the Invention

The present invention relates to the detection of X-rays and, more particularly, to detecting X-rays using a photodiode formed on a thin-film transistor (TFT) substrate.

### Description of the Related Art

An X-ray has such a short wavelength that they may easily penetrate an object, the amount of X-ray penetration depending on the density of the object. Thus, the interior of the object may be indirectly observed by the amount of X-ray penetration. An X-ray detecting apparatus may include a plurality of photodiodes for detecting the amount of X-ray penetration. When the X-rays are incident onto the photodiodes with a reverse bias, the diodes generate a photodetect voltage corresponding to the X-ray penetration. The photodetect voltage is converted into an image signal, and the image signal is applied to a display device so that the display device displays the state of the interior of the object.

The photodiode may include a trap space capable of trapping electric charge. The trap space may be formed by a dangling bond capable of trapping an electron or a hole. When the X-rays enter the photodiode, the electric charge is trapped in the trap space.

The amount of trapped electric charge in the trap space corresponds to the amount of X-rays incident upon the photodiode. Thus, when the amount of the X-rays incident into the photodiode is increased, the amount of the trapped electric charge is increased. When the amount of the X-rays incident into the photodiode is decreased, the amount of the trapped electric charge is decreased.

Discharging the trapped electric charge from the trap space takes considerable time so that a portion of the trapped electric charge which was trapped in a former frame may remain in the trap space in the present frame. Thus, the amount of the trapped electric charge at a particular time frame may be greater than the amount of the trapped electric charge corresponding to the amount of X-rays incident upon the photodiode.

As a result, when an image corresponding to the amount of the X-rays is displayed on the display device, the portion of the trapped electric charge may be displayed as an afterimage on the display device. The afterimage may interfere with the ability of the display device to display the image accurately, and thus adversely affect the image display quality corresponding to the amount of the X-rays.

### SUMMARY OF THE INVENTION

According to one aspect of the present invention, a method of detecting X-rays includes applying a first reverse bias to the photodiode to generate a photodetect voltage in accordance with the X-rays incident upon the photodiode and, after an image signal is output, applying a forward bias to the photodiode.

The first reverse bias includes a reference voltage and a first voltage lower than the reference voltage applied respectively to an n-side electrode and a p-side electrode of the photodiode. The forward bias includes a reference voltage and a second voltage higher than the reference voltage respectively applied to an n-side electrode and a p-side electrode of the photodiode.

After the forward bias is applied to the photodiode, a second reverse bias higher than the first reverse bias may be further applied to the photodiode for more accurate detection of the X-rays.

A second reverse bias may be applied to the photodiode comprising a reference voltage and a third voltage lower than the first voltage respectively applied to an n-side electrode and a p-side electrode of the photodiode.

A first sample voltage applied to a data line is detected, so that the image signal is output by using the photodetect voltage. After the first sample voltage being detected, a second sample voltage is detected. The second sample voltage is a combined voltage of the first sample voltage and the photodetect voltage. Alternatively, a voltage applied to the data line may become the reference voltage by resetting the data line before the first sample voltage is applied to the data line.

A thin-film transistor (TFT) is turned on so that the data line may be electrically connected to the p-side electrode of the photodiode for detecting the second sample voltage.

According to another aspect of the present invention, a method of detecting X-rays comprises applying a forward bias and then a first reverse bias to the photodiode. An image signal is output by using a photodetect voltage which is generated in accordance with X-rays incident upon the photodiode to which the first reverse bias is applied. After the forward bias is applied to the photodiode, a second reverse bias having a higher level than the first reverse bias may be applied to the photodiode before the first reverse bias is applied to the photodiode.

According to one aspect of the present invention, an X-ray detecting apparatus includes a photodetect substrate, a signal outputting part and a bias driving part.

The photodetect substrate may include a photodiode which generates a photodetect voltage in accordance with X-rays incident upon the photodiode. The signal outputting part outputs an image signal in accordance with the photodetect voltage. The bias driving part may include a bias generating part and a bias selecting part. The bias generating part generates a first reverse bias for forming a photodetect voltage and a forward bias for saturating the photodiode with trapped electric charge. The bias selecting part selects the first reverse bias or the forward bias, and the bias selecting part applies the selected one of the first reverse bias and the forward bias to the photodiode.

The photodetect substrate may further include a gate line, a data line, a bias line and a TFT. The gate line is formed along a first direction. The data line is formed along a second direction crossing the first direction to be electrically connected to the signal outputting part. The bias line may electrically connect a p-side electrode of the photodiode with the bias driving part. The TFT includes a gate electrode, a source electrode and a drain electrode which are electrically connected to the gate line, the data line and an n-side electrode of the photodiode, respectively.

The X-ray detecting apparatus may further include a gate driving part electrically connected to the gate line. The gate driving part may turn on or turn off the TFT.

A reference voltage may be formed at the n-side electrode. The bias driving part may apply a first voltage lower than the reference voltage to the p-side electrode so that the bias selecting part may apply the first reverse bias selected by the bias selecting part to the photodiode.

The bias generating part may further generate a second reverse bias higher than the first reverse bias. The bias selecting part may further select the second reverse bias and apply the second reverse bias to the photodiode. The bias driving part may further apply a second voltage lower than the first voltage to the p-side electrode so that the bias driving part may further apply the second reverse bias selected by the bias selecting part to the photodiode.

The data line may transmit a first sample voltage to the signal outputting part when the TFT is turned off, and may transmit a second sample voltage to the signal outputting part when the TFT is turned on. The signal outputting part may output the image signal using the first and second sample voltages.

The signal outputting part may include a photodetect outputting part and an image signal outputting part. The first and second sample voltages are applied to the photodetect outputting part, and then the photodetect outputting part outputs first and second sample signals. The image signal outputting part outputs the image signal using the first and second sample signals.

The photodetect outputting part may include an operational amplifier, an operational capacitor and a reset device. The first and second sample voltages are applied to a first input terminal of the operational amplifier, and the reference voltage is applied to a second input terminal of the operational amplifier. The first and second sample signals are output through an output terminal of the operational amplifier. The operational capacitor is electrically connected to the first input terminal and the output terminal. The reset device resets a charged voltage in the operational capacitor.

According to the method of detecting X-rays and the X-ray detecting apparatus in accordance with the present invention, after an image signal is output in accordance with X-rays incident into a photodiode in the present frame, a forward bias is applied to the photodiode. Thus, the photodiode may be saturated with trapped electrical charge in the photodiode so that an amount of X-ray incidence may be detected more accurately in the next frame.

### BRIEF DESCRIPTION OF THE DRAWINGS

The above and other features and advantages of the present invention will become more apparent by describing the detailed exemplary embodiments thereof with reference to the accompanying drawings, in which:

FIG. 1 is a plan view illustrating an X-ray detecting apparatus in accordance with exemplary embodiments of the present invention;

FIG. 2 is a plan view illustrating a unit pixel of a photodetect substrate employed in the X-ray detecting apparatus in FIG. 1;

FIG. 3 is a cross-sectional view illustrating the unit pixel taken along a line I-I' in FIG. 2;

FIG. 4 is a circuit diagram schematically illustrating the X-ray detecting apparatus in FIG. 1;

FIG. 5 is a block diagram illustrating a bias driving part of the X-ray detecting apparatus in FIG. 4;

FIG. 6 is a timing diagram illustrating a frame during which the X-ray detecting apparatus in FIG. 1 is driven; and

FIG. 7 is a waveform diagram illustrating a signal outputting period of the frame shown in FIG. 6.

### DESCRIPTION OF THE EMBODIMENTS

The present invention is described more fully hereinafter with reference to the accompanying drawings, in which embodiments of the invention are shown. This invention may, however, be embodied in many different forms and should not be construed as limited to the example embodiments set forth herein. Rather, these example embodiments are provided so that this disclosure will be thorough and complete, and will fully convey the scope of the invention to those skilled in the art. In the drawings, the sizes and relative sizes of layers and regions may be exaggerated for clarity.

It will be understood that when an element or layer is referred to as being "on," "connected to" or "coupled to" another element or layer, it can be on, connected to or coupled to the other element or layer, with intervening elements or layers present. In contrast, when an element is referred to as being "directly on," "directly connected to" or "directly coupled to" another element or layer, there are no intervening elements or layers present. Like reference numerals refer to like elements throughout. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (e.g., rotated 90 degrees or at other orientations) and the spatially relative descriptors used herein interpreted accordingly.

The terminology used herein is for the purpose of describing particular embodiments only and is not intended to limit of the invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments of the present invention are described herein with reference to cross-section illustrations that are schematic illustrations of idealized embodiments (and intermediate structures) of the present invention. As such, variations from the shapes of the illustrations as a result, for example, of manufacturing techniques and/or tolerances, are to be expected. Thus, example embodiments of the present invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein

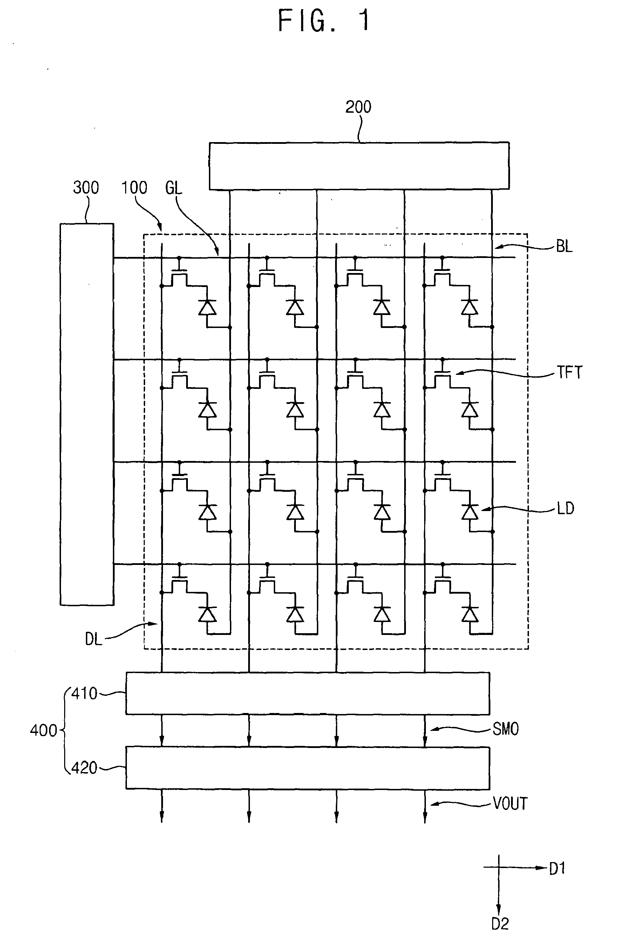

FIG. 1 is a plan view illustrating an X-ray detecting apparatus in accordance with exemplary embodiments of the present invention. Referring to FIG. 1, an X-ray detecting apparatus in accordance with exemplary embodiments includes a photodetect substrate 100, a bias driving part 200, a gate driving part 300 and a signal processing part 400.

X-rays from the exterior are incident into the photodetect substrate 100, and then the photodetect substrate 100 forms a photodetect voltage. The photodetect substrate 100 includes a plurality of gate lines GL, a plurality of data lines DL, a plurality of thin-film transistors (TFT), a plurality of photodiodes LD and a plurality of bias lines BL.

The gate lines GL are formed along a first direction D1. The data lines DL are formed along a second direction D2 crossing the first direction D1. The first and second directions D1 and D2 may be substantially perpendicular to each other. For example, four gate lines GL and four data lines DL are illustrated in FIG. 1.

The TFTs are positioned along the first and second directions D1 and D2 as a matrix shape. Each of the TFTs may be electrically connected to one of the gate lines GL and one of the data lines DL. A gate electrode and a source electrode are electrically connected to each of the gate lines GL and each of the data lines DL, respectively. For example, sixteen TFTs which are positioned along four rows and four columns are illustrated in FIG. 1.

The photodiodes LD correspond to the TFTs, respectively, along the first and second directions D1 and D2 as the matrix shape. Each of the photodiodes LD is electrically connected to each of the TFTs. An n-side electrode is electrically connected to a drain electrode DE of each of the TFTs. For example, sixteen photodiodes LD which are positioned along four rows and four columns are illustrated in FIG. 1.

Externally generated X-rays are incident into each of the photodiodes LD, and then each of the photodiodes LD generates a photodetect voltage. The photodetect voltage may correspond to an amount of X-ray incidence. The photodetect voltage may be formed at the n-side electrodes of the photodiodes LD.

The bias lines BL are electrically connected to the photodiodes LD. Each of the bias lines BL may be electrically connected to a p-side electrode of each of the photodiodes LD being positioned along one direction. Each of the bias lines BL, for example, may be formed substantially parallel with the second direction D2 to be electrically connected to the photodiodes LD. Alternatively, each of the bias lines BL may be formed substantially parallel with the first direction D1 to be electrically connected to the photodiodes LD. For example, four bias lines BL which are formed along the second direction D2 are illustrated in FIG. 1.

The bias driving part 200 electrically connected to the bias lines BL applies a driving voltage to the bias lines BL. The bias driving part 200 may alternately apply a first reverse bias or a forward bias to the photodiodes LD. The bias driving part 200 may further apply a second reverse bias higher than the first reverse bias to the photodiodes LD.

The reference voltage, for example, may be applied to the n-side electrodes of the photodiodes LD. The bias driving part 200 may apply a first voltage lower than the reference voltage to the p-side electrodes of the photodiodes LD so that the bias driving part 200 may apply the first reverse bias to the photodiodes LD. The bias driving part 200 may apply a second voltage higher than the reference voltage to the p-side electrodes of the photodiodes LD so that the bias driving part 200 may apply the forward bias to the photodiodes LD. The bias driving part 200 may apply a third voltage lower than the first voltage to the p-side electrodes of the photodiodes LD so that the bias driving part 200 may apply the second reverse bias to the photodiodes LD.

The reference voltage, for example, may be in a range of about 1 V to about 2 V, and the first voltage may be in a range of about -4 V to about -3 V. The second voltage may be in a range of about 2.5 V to about 3.5 V, and the third voltage may be in a range of about -9 V to about -8 V. Desirably, the reference voltage, the first voltage, the second voltage and the third voltage may be about 1.5 V, about -3.5 V, about 3 V and about -8.5 V, respectively.

As a result, the first reverse bias may be in a range of about 4 V to about 6 V, and the forward bias may be in a range of about 1 V to about 2 V. The second reverse bias may be in a range of about 9 V to about 11 V. Desirably, the first reverse bias, the forward bias and the second reverse bias may be about 5 V, about 1.5 V, and about 10 V, respectively.

The gate driving part 300 that is electrically connected to each of the gate lines GL applies gate signals to the gate lines GL. The gate driving part 300 sequentially applies the gate signals to the gate lines GL along the second direction D2. When the gate signals, for example, are applied to the gate lines GL, the TFTs may be turned on by the gate signals. When the gate signals are not applied to the gate lines GL, the TFTs may be turned off by the gate signals.

The signal processing part 400 which is electrically connected to the data lines DL receives a sample input voltage through the data lines DL. The sample input voltage may include a first sample voltage and a second sample voltage.

The signal processing part 400 may receive the first sample voltage through the data line DL when the TFT is turned off. The first sample voltage, for example, may be a noise voltage applied to each of the data lines DL.

The signal processing part 400 may receive the second sample voltage through the data line DL when the TFT is turned on. When each of the TFTs is turned on, each of the data lines DL is electrically connected to the n-side electrode of each of the photodiodes LD and the photodetect voltage generated at the n-side electrode may be transmitted to the signal processing part 400 through each of the TFTs and each of the data lines DL. The second sample voltage, for example, may be a combined voltage of the photodetect voltage and the noise voltage.

The signal processing part 400 may output an image signal VOUT using the first and second sample signals. The image signal VOUT may be an analog signal or a digital signal corresponding to the photodetect voltage. The signal processing part 400 may remove the first sample voltage from the second sample voltage so that the signal processing part 400 may generate the photodetect voltage, which is without the noise voltage, and may output the image signal VOUT in response to the photodetect voltage.

The signal processing part 400 may include a photodetect outputting part 410 and an image signal outputting part 420.

The photodetect outputting part 410 is electrically connected to the data lines DL. The photodetect outputting part 410 receives the first and second sample voltages through each of the data lines DL. The photodetect outputting part 410 outputs the first and second sample signals in response to the first and second sample voltages. The first sample signal may be an analog signal corresponding to the first sample voltage, and the second sample signal may be an analog signal corresponding to the second sample voltage.

The photodetect outputting part 410 applies the first and second sample signals to the image signal outputting part 420 which is electrically connected to the photodetect outputting part 410. The image signal outputting part 420 outputs the image signal VOUT in response to the first and second sample signals. Thus, the image signal outputting part 420 may remove the first sample signal from the second sample signal so that the image signal outputting part 420 may output the image signal VOUT in response to the photodetect voltage.

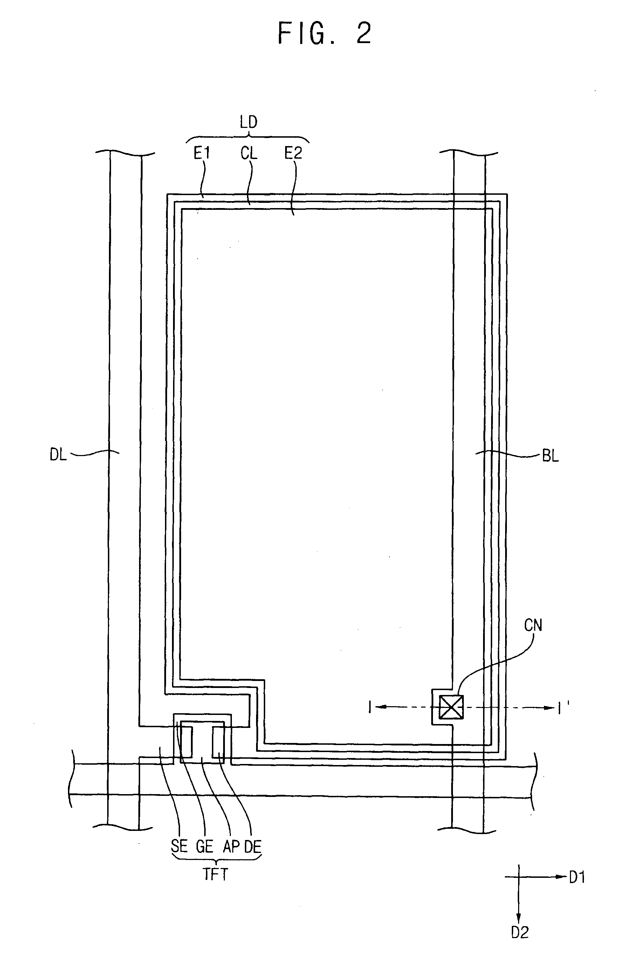

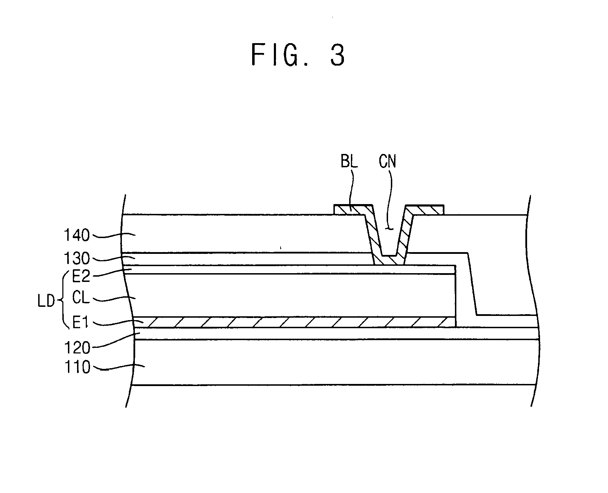

FIG. 2 is a plan view illustrating a unit pixel of a photodetect substrate 100 employed in the X-ray detecting apparatus in FIG. 1. FIG. 3 is a cross-sectional view illustrating the unit pixel taken along a line I-I' in FIG. 2.

Referring to FIGS. 2 and 3, the photodetect substrate 100 may further include a base substrate 110, a gate insulation layer 120, a passivation layer 130 and an organic insulation layer 140. Each of the TFTs may include a gate electrode GE, an active pattern AP, a source electrode SE and a drain electrode DE. Each of the photodiodes LD may include a first electrode E1, a photoconductive layer CL and a second electrode E2.

The base substrate 110 may have a plate shape. The base substrate 110 may be formed of transparent material such as glass, quartz or plastic.

The gate lines GL are formed on the base substrate 110 along the first direction D1. The gate lines GL may be formed of aluminum (Al) or an aluminum (Al) alloy.

The gate electrode GE may be formed on the base substrate 110 to protrude from each of the gate lines GL. The gate electrode GE may protrude from each of the gate lines GL to be substantially parallel with the second direction D2. The gate electrode GE may be formed of the same material of which the gate lines GL are formed.

The gate insulation layer 120 is formed on the base substrate 110 to cover the gate lines GL. The gate insulation layer 120 may be formed of silicon nitride (SiNx), silicon oxide (SiOx), etc.

The active pattern AP may be formed on the gate insulation layer 120 to overlap the gate electrode GE. The active pattern AP may include a channel layer formed on the gate insulation layer 120 and an ohmic contact layer formed on the channel layer. The channel layer may include amorphous silicon. The ohmic contact layer may include amorphous silicon which is doped with impurities at a high density.

The data lines DL are formed on the gate insulation layer 120 along the second direction D2. The data lines DL, for example, may include molybdenum (Mo), a molybdenum-tungsten (MoW) alloy, chromium (Cr), tantalum (Ta), titanium (Ti), etc. The data lines DL may form a multilayer structure which includes a conductive layer having low electrical resistance and a contact layer formed of a material having good contact properties. Each of the data lines DL may include an aluminum-chromium (AlCr) alloy, an aluminum-molybdenum (AlMo) alloy, etc.

The source electrode SE may be formed on the gate insulation layer 120 to protrude from each of the data lines DL. The source electrode SE may protrude from each of the data lines DL to be substantially parallel with the first direction D1. A part of the source electrode SE is formed on the active pattern AP to overlap the active pattern AP. The drain electrode DE may be formed on the gate insulation layer 120 to be spaced apart from the source electrode SE. A part of the drain electrode DE is formed on the active pattern AP to overlap the active pattern AP. The source and drain electrodes SE and DE may be formed of the same material of which the data lines DL are formed.

The ohmic contact layer of the active pattern AP contacts with the source and drain electrodes SE and DE. The ohmic contact layer may be formed only beneath the source and drain electrodes SE and DE.

The first electrode E1 of each of the photodiodes LD is formed on the gate insulation layer 120 to be spaced apart from each of the data lines DL. The first electrode E1 is formed on the unit pixel so that the first electrode E1 may not overlap each of the gate lines GL. The first electrode E1 is electrically connected to the drain electrode DE. The first electrode E1 may be formed of the same material of which the drain electrode DE is formed.

The photoconductive layer CL of each of the photodiodes LD is formed on the first electrode E1. The photoconductive layer CL of each of the photodiodes LD has substantially the same size as the first electrode E1.

The photoconductive layer CL may include an n-type silicon layer and a p-type silicon layer. The photoconductive layer CL may further include an intrinsic silicon layer. The n-type silicon layer is formed on the first electrode E1. The n-type silicon layer may be an amorphous silicon layer having n-type impurities. The intrinsic silicon layer is formed on the n-type silicon layer. The intrinsic silicon layer may be an amorphous silicon layer without impurities. The p-type silicon layer is formed on the intrinsic silicon layer. The p-type silicon layer may be an amorphous silicon layer having p-type impurities.

The second electrode E2 of each of the photodiodes LD is formed on the photoconductive layer CL. Thus, the second electrode E2 is formed on the p-type silicon layer. The second electrode E2 may be formed of transparent conductive material to allow X-rays incident into the interior of the photoconductive layer CL. The second electrode E2, for example, may include indium tin oxide (ITO), indium zinc oxide (IZO), etc.

In exemplary embodiments, the first electrode E1 may be considered as the n-side electrode and the second electrode E2 may be considered as the p-side electrode.

The passivation layer 130 may be formed on the gate insulation layer 120 to cover the photodiodes LD, the TFTs and the data lines DL. The passivation layer 130, for example, may be formed of silicon nitride (SiNx), silicon oxide (SiOx), etc.

The organic insulation layer 140 may be formed on the passivation layer 130. The organic insulation layer 140 may have a thickness greater than about 2 µm. An upper surface of the organic insulation layer 140 may be substantially parallel with the base substrate 110.

A contact hole CN may be formed on the passivation layer 130 and the organic insulation layer 140 to partially expose the second electrode E2.

The bias lines BL may be formed on the organic insulation layer 140. The bias lines BL may be substantially parallel with the second direction D2. Each of the bias lines BL is electrically connected to the second electrode E2 through the contact hole CN.

In exemplary embodiments, the passivation layer 130 and the organic insulation layer 140 may be alternately formed. In other words, only the selected one of the passivation layer and the organic insulation layer 140 may be formed.

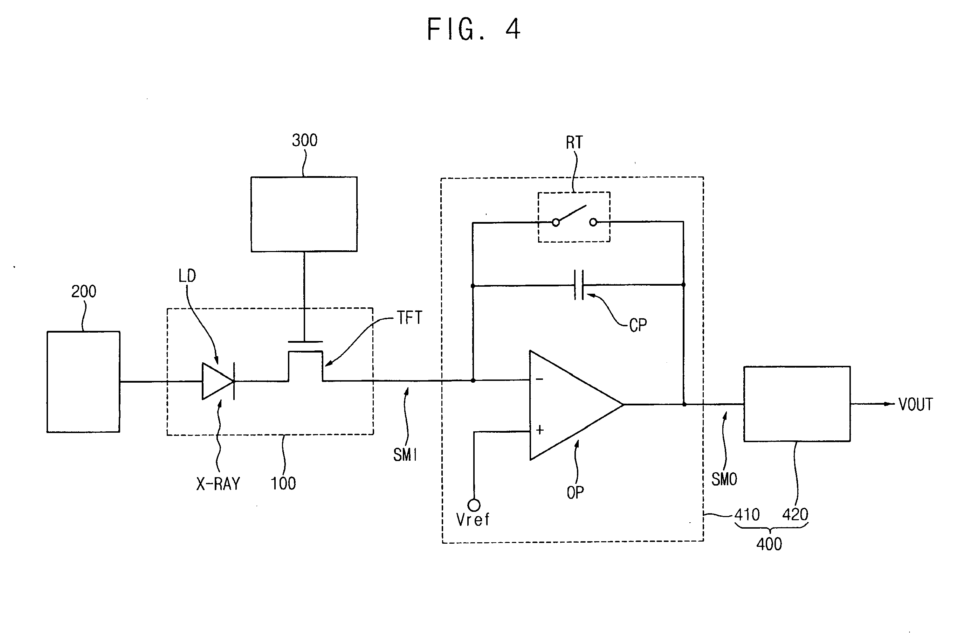

FIG. 4 is a circuit diagram schematically illustrating the X-ray detecting apparatus in FIG. 1.

Referring to FIGS. 1 and 4, the bias driving part 200 is electrically connected to the p-side electrode of each of the photodiodes LD through each of the bias lines BL. The bias driving part 200 may alternately apply the first voltage, the second voltage and the third voltage to the p-side electrode.

The n-side electrode of each of the photodiodes LD is electrically connected to the drain electrode DE of each of the TFTs. The reference voltage Vref may be applied to the n-side electrode.

The gate driving part 300 is electrically connected to the gate electrode GE of each of the TFTs through each of the gate lines GL. The gate driving part 300 may apply the gate signals to the gate electrode GE.

The source electrode SE of each of the TFTs is electrically connected to the photodetect outputting part 410 through each of the data lines DL. The photodetect outputting part 410 may receive the sample input voltage SMI including the first and second sample voltages through each of the data lines DL. The photodetect outputting part 410 may output a sample output signal SMO in response to the sample input voltage SMI. The sample output signal SMO may include the first sample signal corresponding to the first sample voltage and the second sample signal corresponding to the second sample voltage.

The photodetect outputting part 410 may include an operational amplifier OP, an operational capacitor CP and a reset device RT.

The operational amplifier OP may include a first input terminal, a second input terminal and an output terminal. The sample input voltage SMI is applied to the first input terminal, and the reference voltage Vref is applied to the second input terminal. The sample output signal SMO is output through the output terminal of the operational amplifier OP. The first input terminal may be a negative terminal of the operational amplifier OP, and the second input terminal may be a positive terminal of the operational amplifier OP. The reference voltage Vref applied to the second input terminal may be applied to the n-side electrode through the first input terminal.

The operational capacitor CP is electrically connected to the first input terminal and the output terminal. A first end portion of the operational capacitor CP is electrically connected to the first input terminal of the operational amplifier OP and a second end portion of the operational capacitor CP is electrically connected to the output terminal of the operational amplifier OP.

The reset device RT resets a charged voltage in the operational capacitor CP. A first end portion of the reset device RT is electrically connected to the first end portion of the operational capacitor CP and a second end portion of the reset device RT is electrically connected to the second end portion of the operational capacitor CP.

The reset device RT may include a switching device capable of electrically connecting the first and second end portions of the operational capacitor CP with each other. In exemplary embodiments, when the switching device is closed, the first and second end portions of the operational capacitor CP may be electrically connected with each other. As a result, a charged voltage stored in the first and second end portions of the operational capacitor CP may be reset. When the charged voltage in the first and second end portions of the operational capacitor CP is reset, the reference voltage Vref may be generated at each of the data lines DL.

The output terminal of the operational amplifier OP is electrically connected to the image signal outputting part 420. The image signal outputting part 420 outputs the sample output signal SMO. The image signal outputting part 420 outputs the image signal VOUT in response to the sample output signal SMO.

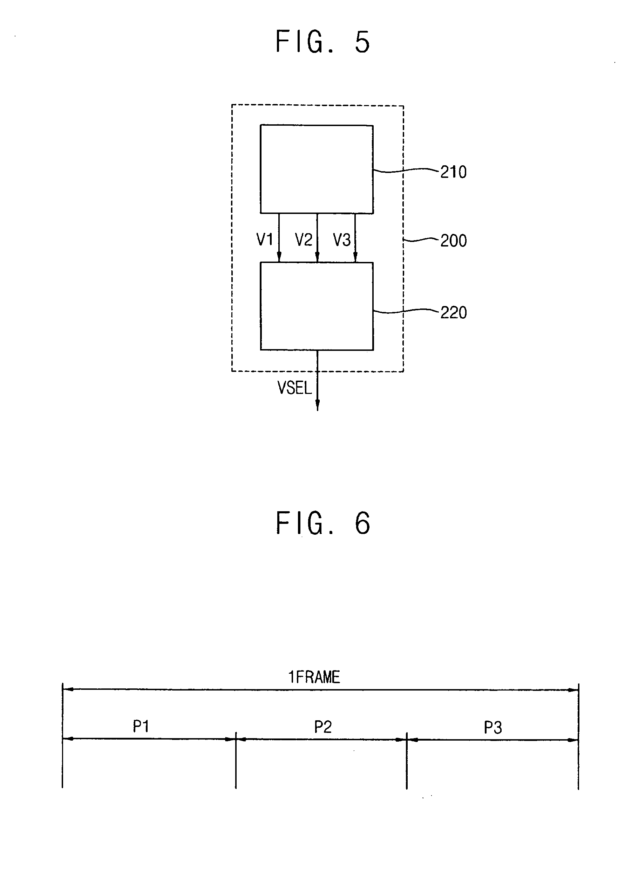

FIG. 5 is a block diagram illustrating a bias driving part 200 of the X-ray detecting apparatus in FIG. 4.

Referring to FIG. 5, the bias driving part 200 may include a bias generating part 210 and a bias selecting part 220. The bias generating part 210 generates the first reverse bias and the forward bias. The bias selecting part 220 selects one of the first reverse bias and the forward bias to apply the selected one of the first reverse bias and the forward bias to each of the photodiodes LD.

The bias generating part 210 may output a first voltage V1 for generating the first reverse bias, a second voltage V2 for generating the forward bias and a third voltage V3 for generating the second reverse bias.

The bias selecting part 220 receives the first, second and third voltages V1, V2 and V3 from the bias generating part 210. The bias selecting part 220 may select one VSEL of the first, second and third voltages V1, V2 and V3. The bias selecting part 220 may apply the selected one VSEL to the p-side electrode of each of the photodiodes LD.

The reference voltage Vref is applied to the p-side electrode of each of the photodiodes LD. The first voltage V1 is lower than the reference voltage Vref. The second voltage V2 is higher than the reference voltage Vref. The third voltage V3 is lower than the first voltage V1.

FIG. 6 is a timing diagram illustrating a frame during which the X-ray detecting apparatus in FIG. 1 is driven;

Referring to FIGS. 1, 4 and 6, one frame during which the X-ray detecting apparatus is driven may include a period of X-ray incidence P1, a period of signal outputting P2 and a period of frame margin P3. The period of frame margin P3 may be referred to as a time interval after the period of signal outputting P2 and before the start of the next frame.

The X-ray detecting apparatus receives X-rays and generates the photodetect voltage during the period of X-ray incidence P1. The period of X-ray incidence P1 may include a period of applying a bias and a period of applying X-rays.

The first reverse bias is applied to each of the photodiodes LD during the period of applying a bias. Thus, the reference voltage Vref is applied to the n-side electrode of each of the photodiodes LD, and the first voltage V1 lower than the reference voltage Vref is applied to the p-side electrode of each of the photodiodes LD.

For example, the reference voltage Vref applied to the second input terminal of the operational amplifier OP may be transmitted to the n-side electrode through each of the data lines DL and each of the TFTs. The bias driving part 200 may apply the first voltage V1 to the p-side electrode through each of the bias lines BL.

The X-rays are applied to each of the photodiodes LD to which the first reverse bias is applied during the period of applying the X-rays. When the X-rays, for example, are applied to each of the photodiodes LD, electrons and electric holes may be generated in the interior of each of the photodiodes LD. Thus, electric charge may be formed in the interior of each of the photodiodes LD by the X-rays.

The electric charge generated by the X-rays may be transmitted to the n-side electrode or the p-side electrode, and may be trapped in a trap space of each of the photodiodes LD. As a result, the photodetect voltage may be generated in each of the photodiodes LD. The voltage of the p-side electrode is fixed to the first voltage V1, and thus the photodetect voltage may be generated at the n-side electrode.

The photodetect voltage generated at the n-side electrode corresponds to an amount of X-rays applied to each of the photodiodes LD. Thus, when the amount of the X-rays is increased, the photodetect voltage is increased, and when the amount of X-rays is decreased, the photodetect voltage is decreased. The photodetect voltage generated in each of the photodiodes LD positioned along a matrix shape may be substantially equal to each other, or may be different from each other.

The trap spaces of the photodiodes LD may substantially have the same receiving capacity. Thus, the trap spaces of the photodiodes LD may receive the maximum amount of the same electrical charge.

After the period of X-ray incidence P1, the period of signal outputting P2 during which the image signal VOUT is output is performed. The period of signal outputting P2 may include a plurality of unit periods of signal outputting. The unit periods of signal outputting may correspond one-to-one to the gate signals which are sequentially generated along the second direction D2.

The period of signal outputting P2, for example, may include four unit periods of signal outputting, and the TFTs and the photodiodes LD are positioned in a four-by-four matrix. Thus, a first unit period of signal outputting may be performed in response to a first gate signal, and a second unit period of signal outputting may be performed in response to a second gate signal. A third unit period of signal outputting may be performed in response to a third gate signal, and a fourth unit period of signal outputting may be performed in response to a fourth gate signal.

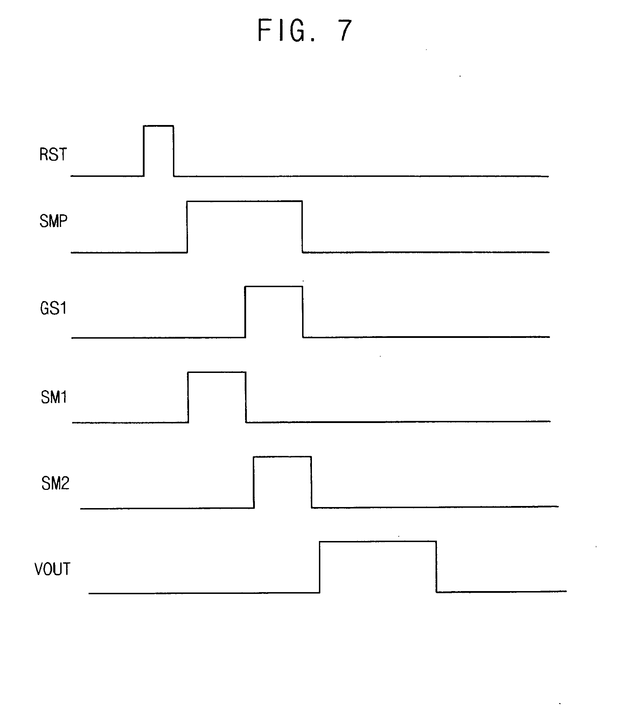

FIG. 7 is a waveform diagram illustrating a signal outputting period of the frame shown in FIG. 6.

Referring to FIGS. 1, 4 and 7, the first unit period of signal outputting may be described because the plurality of unit periods of signal outputting may be performed as substantially the same course.

A reset signal RST is applied to the reset device RT so that the first and second end portions of the operational capacitor CP may be reset with the reference voltage Vref. Thus, a voltage charged in the first and second end portions of the operational capacitor CP in the previous frame may be removed.

After the reset signal RST is applied, a sampling control signal SMP is applied to the photodetect outputting part 410, and then the photodetect outputting part 410 receives a voltage generated in each of the data lines DL.

The first gate signal GS1 is applied to each of the TFTs while the sampling control signal SMP is applied. The first gate signal GS1 turns on each of the TFTs so that the n-side electrode and each of the data lines DL are electrically connected to each other. Then, the photodetect voltage is transmitted to the photodetect outputting part 410 through each of the data lines DL.

As a result, the photodetect outputting part 410 receives the first sample voltage through each of the data lines DL when each of the TFTs is turned off, and the photodetect outputting part 410 receives the second sample voltage through each of the data lines DL when each of the TFTs is turned on. The first sample voltage may be the noise voltage applied to each of the data lines DL and the second sample voltage may be a combined voltage of the photodetect voltage and the noise voltage.

The first sample voltage is applied to the photodetect outputting part 410, and then the photodetect outputting part 410 outputs the first sample signal SM1. The second sample voltage is applied to the photodetect outputting part 410, and then the photodetect outputting part 410 outputs the second sample signal SM2.

The image signal outputting part 420 receives the first and second sample signals SM1 and SM2, and outputs the image signal VOUT corresponding to the difference between the first and second sample signals SM1 and SM2.

The second, the third and the fourth unit periods of signal outputting are sequentially performed after the first unit period of signal outputting corresponding to the first gate signal GS1 is performed.

Referring to FIGS. 1, 4 and 6, the period of frame margin P3 is performed after the period of signal outputting P2 is performed. The period of frame margin P3 may include a period of a forward bias and a period of a reverse bias.

The forward bias is applied to each of the photodiodes LD during the period of a forward bias. The reference voltage Vref, for example, may be applied to the n-side electrode of each of the photodiodes LD and the bias driving part 200 may apply the second voltage V2 higher than the reference voltage Vref to the p-side electrode of each of the photodiodes LD.

When the forward bias is applied to each of the photodiodes LD, the trap space of each of the photodiodes LD may be filled with the trapped electrical charge to the limit of the receiving capacity. Thus, the amount of the trapped electrical charge in each of the photodiodes LD may substantially be equal to each other.

The trapped electrical charge in the trap space of each of the photodiodes LD is slowly discharged at substantially the same speed as each other. Thus, the photodiodes LD may have substantially the same amount of the trapped electrical charge as each other when other externally generated X-rays are applied to the photodiodes LD in the next frame.

The photodiodes LD may have substantially the same amount of the trapped electrical charge as each other in the next frame, which may prevent the photodetect voltages generated in the photodiodes LD in the present frame from having an effect on the photodetect voltages generated in the next frame. As a result, an image displayed in the present frame may be prevented from being displayed as an afterimage in the next frame.

The period of a reverse bias may be performed after the period of a forward bias is performed.

The second reverse bias is applied to each of the photodiodes LD during the period of a reverse bias. The reference voltage Vref, for example, may be generated at the n-side electrode of each of the photodiodes LD and the bias driving part 200 may apply the third voltage V3 lower than the first voltage V1 to the p-side electrode of each of the photodiodes LD.

When other externally generated X-rays are applied to the photodiodes LD in the next frame, that most of the trapped electrical charge has been discharged is advantageous to the X-ray detecting apparatus. However, the trapped electrical charge in the trap space of each of the photodiodes LD is slowly discharged to the exterior, and thus a time for most of the trapped electric charge to be discharged from the trap space may be relatively long.

In exemplary embodiments, when the period of a reverse bias is performed after the period of a forward bias is performed, the trapped electrical charge in the trap space may be more quickly discharged to the exterior, and thus a time for most of the trapped electric charge to be discharged from the trap space may be decreased.

Alternatively, one frame during which the X-ray detecting apparatus is driven may be performed in the following sequence: the period of frame margin P3, the period of X-ray incidence P1 and the period of signal outputting P2.

According to exemplary embodiments of the present invention, after X-rays are applied to photodiodes LD, which a first reverse bias is applied to, a forward bias is equally applied to each of the photodiodes LD. Thus, an image displayed in the present frame may be prevented from being displayed as an afterimage in the next frame.

After the forward bias is applied to the photodiodes LD, a second reverse bias higher than the first reverse bias is applied to the photodiodes LD. Thus, a time for most of the trapped electric charge to be discharged from the trap space may be decreased.

The foregoing is illustrative of the present invention and is not to be construed as limiting thereof. Although exemplary embodiments of the present invention have been described, those skilled in the art will readily appreciate that many modifications of the exemplary embodiments are possible without materially departing from the novel teachings and advantages of the present invention. Accordingly, all such modifications are intended to be included within the scope of this invention as defined in the claims. It is to be understood that the foregoing is illustrative of the present invention and is not to be construed as limited to the embodiments disclosed, and that modifications to the disclosed embodiments, as well as other embodiments, are intended to be included within the scope of the appended claims. The present invention is defined by the following claims, with equivalents of the claims to be included therein.

## Claims

1. A method of detecting X-rays, comprising:
applying a first reverse bias to a photodiode;
outputting an image signal corresponding to an amount of the X-rays applied to the photodiode using a photodetect voltage generated by the X-rays; and
applying a forward bias to the photodiode.

2. The method of claim 1, wherein applying the first reverse bias comprises:
applying a reference voltage to an n-side electrode of the photodiode; and
applying a first voltage lower than the reference voltage to a p-side electrode of the photodiode.

3. The method of claim 2, wherein applying the forward bias comprises:
applying the reference voltage to the n-side electrode; and applying a second voltage higher than the reference voltage to the p-side electrode.

4. The method of claim 3, wherein the reference voltage is in a range of about 1 V to about 2 V, the first voltage is in a range of about -4 V to about -3 V and the second voltage is in a range of about 2.5 V to about 3.5 V.

5. The method of claim 3, further comprising applying a second reverse bias higher than the first reverse bias to the photodiode.

6. The method of claim 5, wherein applying the second reverse bias comprises:
applying the reference voltage to the n-side electrode; and applying a third voltage lower than the first voltage to the p-side electrode.

7. The method of claim 6, wherein the reference voltage is in a range of about 1 V to about 2 V, the first voltage is in a range of about -4 V to about -3 V, the second voltage is in a range of about 2.5 V to about 3.5 V and the third voltage is in a range of about -9 V to about -8 V.

8. The method of claim 1, wherein outputting the image signal comprises:
detecting a first sample voltage applied to a data line;
detecting a second sample voltage, which is a combined voltage of the first sample voltage and the photodetect voltage; and
outputting the image signal using the first and second sample voltages.

9. The method of claim 8, wherein detecting the second sample voltage comprises turning on a thin-film transistor (TFT) so that the data line and the p-side electrode are electrically connected to each other.

10. The method of claim 8, further comprising resetting a voltage applied to the data line by the reference voltage before the first sample voltage is applied to the data line.

11. A method of detecting X-rays, comprising:
applying a forward bias to a photodiode;
applying a first reverse bias to the photodiode; and
outputting an image signal corresponding to an amount of the X-rays applied to the photodiode using a photodetect voltage generated by the X-rays.

12. The method of claim 11, further comprising applying a second reverse bias higher than the first reverse bias to the photodiode after the forward bias is applied to the photodiode, before the first reverse bias is applied to the photodiode.

13. An X-ray detecting apparatus, comprising:
a photodetect substrate comprising a photodiode which generates a photodetect voltage in response to X-rays applied to the photodiode;
a signal outputting part outputting an image signal in accordance with the photodetect voltage; and
a bias driving part, comprising:
a bias generating part generating a first reverse bias for generating the photodetect voltage and a forward bias for saturating the photodiode with trapped electric charge; and
a bias selecting part selecting the first reverse bias or the forward bias, the bias selecting part applying the selected one of the first reverse bias and the forward bias to the photodiode.

14. The apparatus of claim 13, wherein the photodetect substrate further comprises:
a gate line formed along a first direction;
a data line formed along a second direction crossing the first direction to be electrically connected to the signal outputting part;
a bias line electrically connecting a p-side electrode of the photodiode with the bias driving part; and
a TFT comprising a gate electrode, a source electrode and a drain electrode which are electrically connected to the gate line, the data line and an n-side electrode of the photodiode, respectively.

15. The apparatus of claim 14, further comprising a gate driving part electrically connected to the gate line, the gate driving part turning on or turning off the TFT.

16. The apparatus of claim 14, wherein a reference voltage is generated at the n-side electrode, and
the bias driving part applies a first voltage lower than the reference voltage to the p-side electrode so that the bias selecting part applies the first reverse bias selected by the bias selecting part to the photodiode, and
the bias driving part applies a second voltage higher than the reference voltage to the p-side electrode so that the bias selecting part applies the forward bias selected by the bias selecting part to the photodiode.

17. The apparatus of claim 16, wherein the bias generating part generates a second reverse bias higher than the first reverse bias, and
the bias selecting part further selects the second reverse bias and applies the second reverse bias to the photodiode, and
the bias driving part further applies the second voltage lower than the first voltage to the p-side electrode so that the bias driving part further applies the second reverse bias selected by the bias selecting part to the photodiode.

18. The apparatus of claim 14, wherein the signal outputting part receives a first sample voltage through the data line when the TFT is turned off and a second sample voltage to the signal outputting part when the TFT is turned on, and
the signal outputting part outputs the image signal using the first and second sample voltages.

19. The apparatus of claim 18, where the signal outputting part comprises:
a photodetect outputting part to which the first and second sample voltages are applied, and then the photodetect outputting part outputs first and second sample signals; and
an image signal outputting part outputting the image signal using the first and second sample signals.

20. The apparatus of claim 19, wherein the photodetect outputting part comprises:
an operational amplifier comprising a first input terminal to which the first and second sample voltages are applied, a second input terminal to which the reference voltage is applied and an output terminal through which the first and second sample signals are output;
an operational capacitor electrically connected to the first input terminal and the output terminal; and
a reset device resetting a charged voltage in the operational capacitor.
